# EUROPÄISCHE PATENTSCHRIFT

(11) **EP 0 345 881 B1**
(45) Veröffentlichungstag und Bekanntmachung des Hinweises auf die Patenterteilung: **22.11.1995**
(21) Anmeldenummer: 89201407.7
(22) Anmeldetag: 02.06.1989
(51) Int. Cl.: H03D 1/22, H04N 5/60

(54) **Synchrondemodulator**
Synchronous demodulator
Démodulateur synchrone

(30) Priorität: 08.06.1988 DE 3819461; 08.06.1988 DE 3819460
(43) Veröffentlichungstag der Anmeldung: 13.12.1989
(73) Patentinhaber: Philips Patentverwaltung GmbH, 22335 Hamburg (DE); Philips Electronics N.V., 5621 BA Eindhoven (NL)
(72) Erfinder: Brilka, Joachim, D-2000 Hamburg 70 (DE); Weltersbach, Wolfgang, D-2000 Hamburg 54 (DE)
(74) Vertreter: Peters, Carl Heinrich, Dipl.-Ing.

(56) Entgegenhaltungen:
- DE-A- 2 843 977
- US-A- 3 647 950
- PATENT ABSTRACTS OF JAPAN, Band 9, Nr. 118 (E-316)[1841], 23. Mai 1985; & JP-A-69 9204 (MITSUBISHI DENKI SANGYO K.K.) 18-01-1985
- IDEM

## Beschreibung

Die Erfindung bezieht sich auf einen Synchrondemodulator gemäß dem Oberbegriff des Hauptanspruchs.

Aus der DE-PS 28 43 977 ist eine Schaltungsanordnung zum Gewinnen der Tonsignale aus einem Fernsehsignal bekannt, bei der dieses Signal zur Gewinnung einer Bezugsschwingung für die Demodulation über einen Verstärker einem auf die ZF-Bildträger-Schwingung abgestimmten Filterkreis und dann einem Begrenzerverstärker zugeführt wird. Durch den Filterkreis wird die ZF-Bildträger-Schwingung mit einem Teil der benachbarten, als Zweiseitenbandsignale übertragenen Schwingungen ausgefiltert. Die so ausgefilterten Schwingungen werden im Begrenzerverstärker stark begrenzt derart, daß die durch die Seitenbänder bewirkte Amplitudenmodulation weitgehend beseitigt ist und am Ausgang des Begrenzerverstärkers ein der ZF-Bildträger-Schwingung entsprechendes Referenzsignal zur Verfügung steht, das einer Einseitenband-Mischstufe zugeführt wird. Auf diesem Signalweg zur Gewinnung der Bezugsschwingung erfolgt außerdem eine Phasendrehung um 90°. Der Mischstufe wird außerdem das die Bildsignal-ZF-Schwingungen enthaltende Signal zugeführt, das auch dem Verstärker und dem Filterkreis zugeleitet wird. In der Mischstufe, die als Phasendiskriminator ausgebildet sein kann, erfolgt eine Demodulation von in den Bildsignal-ZF-Schwingungen enthaltenen Tonsignal-Schwingungen mit dem am Ausgang des Begrenzerverstärkers erhaltenen Referenzsignal.

Die über den Filterkreis 29 geleiteten Schwingungen sind bei dieser Schaltungsanordnung auf den Bereich um die ZF-Bildträger-Schwingung eingeschränkt. Dazu kann der Filterkreis durch einen Einzelkreis mit einer Güte von 50 bis 80 gebildet werden. Unter der Voraussetzung, daß die Amplitudenverteilung der vom Filterkreis durchgelassenen restlichen Seitenbänder wenigstens nahezu symmetrisch um die Frequenz der ZF-Bildträger-Schwingung liegt, bewirken die restlichen Seitenbänder lediglich eine Amplitudenmodulation der ZF-Bildträger-Schwingung. Bei einer asymmetrischen Amplitudenverteilung erhält die ZF-Bildträger-Schwingung zusätzlich eine Störphasenmodulation. Während die (restliche) Amplitudenmodulation durch den Begrenzerverstärker weitestgehend beseitigt wird, gelangt die Störphasenmodulation unverändert in die Mischstufe und verursacht dort Verzerrungen im demodulierten Signal.

Aus den Patent Abstracts of Japan, Band 9, Nr. 118, (E-316), (1148), 23.05.1985, mit Bezug auf JP-A-60-9204, veröffentlicht am 18.01.1985, ist eine Schaltungsanordnung bekannt mit einem multiplizierenden Element 3, dem ein "Referenzsignal" von einem Element 11 über eine Phasenregelschleife PLL2 zugeführt wird. Andererseits wird dem Element 3 in dieser Druckschrift die mit einem Video-Zwischenfrequenzsignal modulierte Trägerschwingung zugeführt und mit dem "Referenzsignal" multiplikativ verknüpft. Das "Referenzsignal" wird außerdem einem Schaltkreis 4 über einen Eingang 4a zugeführt. Im Schaltkreis 4 wird dieses "Referenzsignal" einem Element 41, welches ebenfalls einen Multiplizierer darstellt, an einem ersten Eingang unverzögert und an einem zweiten Eingang um 90° verzögert über ein Element 43 zugeführt. Das "Referenzsignal" vom Element 11 wird durch dieses aus dem Videozwischenfrequenzsignal an einem Eingang T1 der Schaltungsanordnung durch Bandpaßfilterung und Begrenzung abgeleitet.

Das angeführte Dokument zeigt weiterhin, daß in der Stufe 41 das Produkt aus dem unverzögerten "Referenzsignal" und dem um 90° verzögerten "Referenzsignal" gebildet wird. Dieses Produkt wird in einem Element 42 einer Tiefpaßfilterung unterzogen. Das daraus gewonnene Signal wird über einen Anschluß 4b dem Element 11 zugeführt, wobei die Abstimmfrequenz dieses Elements 11 in näherungsweise linearem Zusammenhang mit dem Signal am Anschluß 4b stehen soll. Somit liegt am Anschluß 4a der in diesem Dokument gezeigten Schaltung nur noch das "Referenzsignal" an, d.h. ein wenigstens nahezu sinusförmiges Signal. Wird dieses mit seiner um 90°in der Phase verzögerten Version multipliziert, ergibt sich lediglich ein Signalanteil mit dem Doppelten der Frequenz des "Referenzsignals".

Bei dieser Schaltung wirkt sich somit eine Verstimmung des Schaltkreises 11 auf beide Eingangssignale des Elements 41 gleichermaßen aus. Dadurch werden ebenfalls Störphasenmodulationen hervorgerufen, ohne daß es eine Möglichkeit gibt, diese zu erkennen oder gar zu unterdrücken.

Die Erfindung hat die Aufgabe, eine einfache Anordnung zu schaffen, durch die die beschriebenen Störphasenmodulationen unterdrückt werden können.

Die Aufgabe wird bei einem Synchrondemodulator der eingangs genannten Art durch die kennzeichnenden Merkmale des Hauptanspruchs gelöst.

Es hat sich gezeigt, daß ein wesentlicher Teil der Störphasenmodulation der Referenzschwingung von einer Abweichung zwischen der Mittenfrequenz des Durchlaßbereiches des Filterkreises und der Frequenz der Trägerschwingung und damit der Referenzschwingung herrührt. Eine solche Abweichung wird insbesondere durch Fertigungstoleranzen und Alterungsvorgänge im beschriebenen Synchrondemodulator und damit im Zusammenhang eingesetzten Schaltungsanordnungen hervorgerufen. Um ihre Auswirkungen gering zu halten, weist der Filterkreis nach dem Stand der Technik nur eine mittlere Güte, d.h. eine über der Frequenz verhältnismäßig flach verlaufende Durchlaßkurve auf, um die Auswirkungen der beschriebenen Abweichungen in Grenzen zu halten. Dabei ist jedoch ein Kompromiß zwischen der Selektivität des Filterkreises und den damit verbleibenden Amplitudenmodulationen und der Störphasenmodulation notwendig.

Die Erfindung hat demgegenüber den Vorteil, mit einer einfachen Vorrichtung die Störphasenmodulation praktisch auszuschließen. Der Filterkreis kann dann ohne Nachteil für eine höhere Selektivität zum noch weitergehenden Unterdrücken der Amplitudenmodulation dimensioniert werden. Insgesamt wird dadurch eine sehr amplitudenstabile und phasenreine Referenzschwingung gewonnen, durch die keine merkbaren Störungen mehr in das demodulierte Nutzsignal eingebracht werden.

Bei der Erfindung wird in vorteilhafter Weise die Tatsache ausgenutzt, daß der Multiplizierer beim Überlagern der frequenzmodulierten Trägerschwingung mit der dazu um 90° phasenverschobenen Referenzschwingung neben anderen Verknüpfungsprodukten eine Gleichspannung liefert, deren Wert unmittelbar ein Maß für die Frequenzabweichung der Trägerschwingung von der Durchlaßfrequenz des Filterkreises ist. Es ist dann nämlich mit sehr einfachen schaltungstechnischen Mitteln möglich, diese Gleichspannung als Regelspannung bzw. Stellspannung dem Filterkreis zum Nachsteuern seiner Durchlaßfrequenz zuzuführen. Insbesondere enthält dazu der Filterkreis ein abstimmbares Element, vorzugsweise wenigstens eine abstimmbare Kapazität, dem die Gleichspannung zum Nachsteuern der Durchlaßfrequenz zuführbar ist.

Die Zusammensetzung und die Amplituden der Verknüpfungsprodukte des Multiplizierers sind entscheidend vom Phasenwinkel zwischen der Trägerschwingung und der Referenzschwingung abhängig. Wird ein Synchrondemodulator mit den erfindungsgemäßen Eigenschaften benötigt, der die Verknüpfungsprodukte zwischen der modulierten Trägerschwingung und der Referenzschwingung für den Fall eines Phasenwinkels von im wesentlichen 0° liefern soll, kann dies nach einer Weiterbildung der Erfindung in einfacher Weise durch einen weiteren Multiplizierer erreicht werden, dem die Referenzschwingung in Phase mit der modulierten Trägerschwingung zuführbar ist zum Gewinnen eines (demodulierten) Inphase-Nutzsignals. Bei dieser Anordnung wird ein Multiplizierer nur zur Gewinnung der Stellgröße zum Nachsteuern der Durchlaßfrequenz des Filterkreises, der zweite Multiplizierer nur zur Demodulation des Nutzsignals verwendet. Filterkreis und Begrenzer dienen beiden Multiplizierern gemeinsam.

Bei der in der DE-PS 28 43 977 beschriebenen Anordnung, die nach dem Quasi-Paralleltonverfahren arbeitet, treten Störmodulationen von der Bildträger-Schwingung auf die Tonträger-Schwingungen insbesondere dadurch auf, daß das Quasi-Paralleltonfilter ein Frequenzband endlicher Breite um die Bildträger-Schwingung herum durchläßt. Besonders störend sind dabei Reste des als Seitenbänder der Bildträger-Schwingung auftretenden Bildsignals, die in einem Frequenzabstand von der Bildträger-Schwingung liegen, der dem Abstand der Tonträger-Schwingungen für die Übertragung von Stereo- oder Zweitonsignalen entspricht. Durch Nichtlinearitäten in den Übertragungskennlinien der einzelnen Stufen der beschriebenen Demodulationsanordnung werden dann bestimmte Teile des Bildsignals in die Frequenzlagen der Tonträger-Schwingungen gemischt und führen dort zu bildinhaltsabhängigen Störungen des Tonsignals. Beim sogenannten System B/G sind dies insbesondere Bildsignalreste mit einem Frequenzabstand von 250 kHz zur Bildträger-Schwingung, bei Systemen mit digitalem Unterträger wie z.B. "NICAM-B/G" ergeben sich entsprechend 350 kHz Frequenzabstand.

Zwar ist es grundsätzlich möglich, durch erhöhten schaltungstechnischen Aufwand die Übertragungskennlinien des regelbaren und des weiteren Verstärkers zu linearisieren; es bleibt jedoch die zur Unterdrückung der Amplitudenmodulation der Bildträger-Schwingung unbedingt erforderliche Nichtlinearität des Begrenzerverstärkers und außerdem die notwendigerweise nichtlineare Übertragungskennlinie der Mischstufe.

Um eine einfache Schaltungsanordnung zu schaffen, durch die die beschriebenen Störmodulationen der Tonträger-Schwingungen auf ein Maß reduziert werden, daß sie auch für den Fall der ungünstigsten, d.h. störungsträchtigsten Form der Restmodulation der Bildträger-Schwingung im Tonsignal nicht mehr hörbar sind, weist bei einer Weiterbildung des erfindungsgemäßen Synchrondemodulators der Filterkreis ein Übertragungsminimum (Nullstelle) bei der Frequenz der amplitudenstärksten Tonträger-Schwingung auf.

Dadurch wird in vorteilhafter Weise die Tonträger-Schwingung für die nachträgliche Signalverarbeitung unterdrückt und dadurch die beschriebenen Störmodulationen unterbunden. Voraussetzung dafür ist, daß ein ggf. vorhandener, den Filterkreis speisender Vorverstärker eine Übertragungskennlinie ausreichender Linearität aufweist, um Störmodulationen größerer Amplitude im Signalweg vor dem Filterkreis zu vermeiden, da diese dann in einem Frequenzbereich auftreten würden, in dem das Übertragungsminimum gegebenenfalls nicht mehr wirksam ist.

Es hat sich gezeigt, daß der höhere Schaltungsaufwand zur Linearisierung der Übertragungskennlinie des Vorverstärkers insbesondere bei einem Aufbau innerhalb einer integrierten Schaltung durch einen verbesserten Herstellungsprozeß und einen optimierten Schaltungsaufbau in Grenzen gehalten werden kann. Die Fortbildung der Erfindung kombiniert diesen Vorteil mit einem sehr einfach aufgebauten Filterkreis, da die Ausbildung eines Übertragungsminimums in der Durchlaßkurve des Filterkreises, insbesondere einer Nullstelle oder eines Frequenzbereiches geringer Signalübertragung, mit sehr geringem Schaltungsaufwand möglich ist. Dabei wird eine sehr gute Unterdrückung der Störmodulation erreicht; diese ist auch im Fall der besonders ungünstigen 250 kHz-Bildsignalreste (Restseitenbänder) der Bildträger-Schwingung nicht mehr hörbar.

An dieser Stelle sei bemerkt, daß aus "Fernseh- und Kinotechnik", 41. Jahrgang, Nr. 6, 1987, Seiten 251 ff., sowie aus dem Gerätetyp AMF 2-E32 der Firma Rohde und Schwarz, beschrieben im zugehörigen Handbuch, Ausgabe R38959 vom März 1981, Demodulationsanordnungen zum Gewinnen zweier Tonsignal-Differenzfrequenz-Schwingungen bekannt sind, die für jede Tonsignal-Differenzfrequenz-Schwingung eine separate Anordnung mit je einem Verstärker, Begrenzer und Intercarrier-Mischer aufweisen. Diesen Anordnungen sind besonders angepaßte Filter vorgeschaltet, die jeweils die Bildträger-Schwingung und nur eine der beiden Tonträger-Schwingungen durchlassen. Demgegenüber wird bei der erfindungsgemäßen Demodulationsanordnung der Schaltungsaufwand auf wenigstens die Hälfte reduziert bei einer vergleichbaren Unterdrückung der Störmodulation.

Ferner ist aus der DE-OS 28 14 522 eine Demodulations-Schaltungsanordnung bekannt, die zum Ableiten eines Trägers aus einem zugeführten, amplitudenmodulierten ZF-Signal eine Träger-Ableitungsschaltung mit einer abgestimmten Schaltung enthält. Diese ist als Fallenschaltung aus der Reihenschaltung paralleler Schwingkreise gebildet. Sie gewinnt aus dem ZF-Signal den Träger und sperrt eine Tonsignalkomponente des ZF-Signals (amplitudenmoduliertes Fernsehsignal).

In einem Synchrondemodulator, bei dem der Filterkreis einen Sperrkreis enthält, der eine Arbeitsimpedanz des Vorverstärkers überbrückt, ist vorteilhaft das Übertragungsminimum durch wenigstens einen in Reihe zum Sperrkreis angeordneten Längskondensator gebildet. Der beschriebene Verlauf der Durchlaßkurve des Filterkreises wird damit durch Hinzufügen eines einfachen Bauteils zu dem bisher gebräuchlichen Sperrkreis gewonnen. Dabei ist es unschädlich, daß der Filterkreis durch den Längskondensator ein zusätzliches Übertragungsmaximum bei niedrigen Frequenzen erhält, da diese durch voraufgehende und nachfolgende Filter unterdrückt werden.

An dieser Stelle sei bemerkt, daß es aus "Funkschau" 1976, Heft 10, Seite 397, im Prinzip bekannt ist, durch die Video-Gleichrichtung entstehende Oberwellen von Seitenbändern mit einer Grund-Frequenz um 1,7 und 2,7 MHz unterhalb des Bildträgers mit Hilfe eines Parallel-Serienkreises (Dreipunktkreis) zu unterdrücken. Dieser Dreipunktkreis umfaßt eine Parallelschaltung aus einer Induktivität und einer Kapazität, die mit einer weiteren Kapazität in Reihe liegt, wozu parallel eine Drossel angeordnet ist. Die in dieser Literatur beschriebene Maßnahme ist nur bei der Gewinnung der modulierten Tonträger-Schwingung durch gemeinsame Demodulation mit dem Bildsignal im Video-Gleichrichter wirksam.

Bei dem Synchrondemodulator nach vorstehend beschriebener Weiterbildung werden in dem durch den Filterkreis und den Begrenzer gebildeten Signalverarbeitungszweig die Anteile des Fernsehsignals unterdrückt, die vom Quasi-Paralleltonfilter und von einem Vorverstärker für das Nutzsignal möglichst unverfälscht übertragen werden müssen, da sie letztlich zu gewinnende Tonsignale enthalten. Grundsätzlich kann eine derartige Unterdrückung auch durch einen Filterkreis hoher Güte oder ein entsprechend ausgebildetes Bandfilter erreicht werden. Während jedoch das Bandfilter einen erhöhten Schaltungs- und Abgleichaufwand bedeutet, weist ein (einkreisiges) Filter hoher Güte einen sehr schmalen Durchlaßbereich für die Bildträger-Schwingung auf. Dies bedeutet eine gute Abtrennung der Restseitenbänder von der Bildträger-Schwingung, wobei die Alterungsvorgänge bzw. Fertigungs- oder Abstimmtoleranzen, die zu einer Verschiebung zwischen dem Durchlaßmaximum und der Frequenz der Bildträger-Schwingung führen, durch die erfindungsgemäßen Maßnahmen ausgeglichen werden.

Weitere vorteilhafte Ausgestaltungen der Erfindung sind Gegenstand der Unteransprüche.

Ausführungsbeispiele der Erfindung sind in der Zeichnung dargestellt und werden im nachfolgenden näher beschrieben.

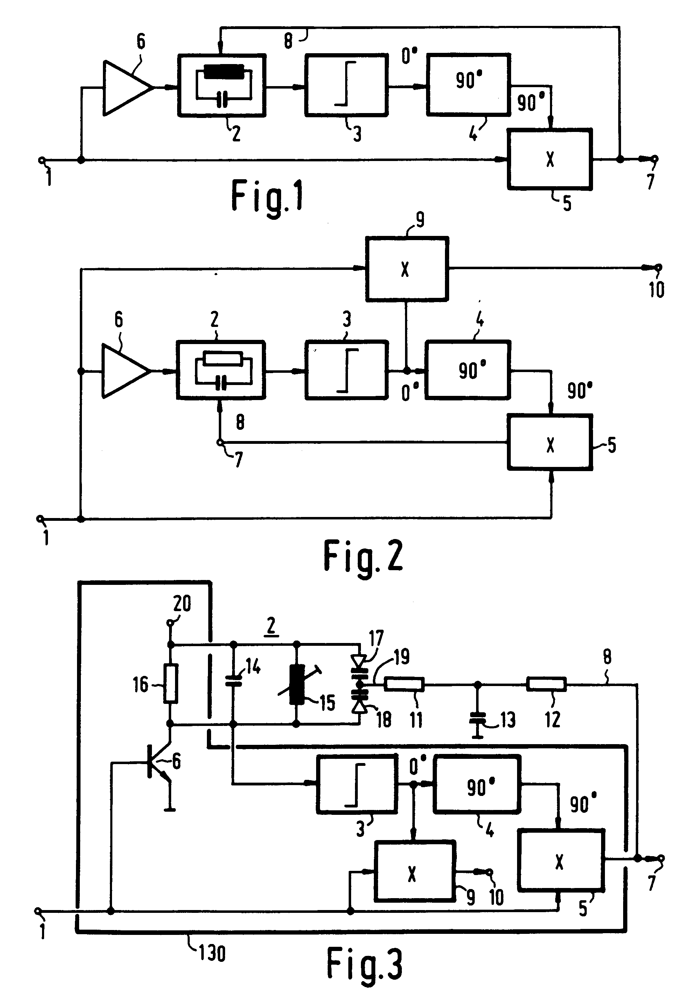

Fig. 1 zeigt ein Blockschaltbild eines Beispiels für einen erfindungsgemäßen Synchrondemodulator. Darin wird eine mit einem Nutzsignal modulierte Trägerschwingung von einem Eingang 1 aus einerseits über einen Filterkreis 2, einen Begrenzer 3 und einen Phasendreher 4 und andererseits unmittelbar jeweils einem Eingang eines Multiplizierers 5 zugeleitet. In den Signalweg zwischen dem Eingang 1 und dem Filterkreis 2 kann außerdem wahlweise ein Vorverstärker 6 eingefügt sein. Im Filterkreis 2 wird die (ggf. verstärkte) modulierte Trägerschwingung wenigstens weitgehend von ihr frequenzmäßig benachbarten Schwingungen befreit; d.h. die Trägerschwingung wird nur mit einem Teil der benachbarten, ihr aufmodulierten Seitenbänder ausgefiltert. Der Grad der Unterdrückung wird durch die Form der Durchlaßkurve, d.h. den Verlauf des Übertragungsfaktors des Filterkreises 2 über der Frequenz bestimmt. Um den Schaltungsaufwand für den Filterkreis 2 gering zu halten, ist jedoch dessen Selektivität in der Regel begrenzt, so daß noch ein merklicher Anteil der Seitenbänder der Trägerschwingung den Filterkreis 2 passiert.

Im anschließenden Begrenzer 3 wird die Trägerschwingung mitsamt den übertragenen Resten der Seitenbänder verstärkt und auf eine vorgegebene Amplitude begrenzt, so daß am Ausgang des Begrenzers 3 eine amplitudenbegrenzte, im wesentlichen rechteckförmig verlaufende Referenzschwingung abgegeben wird. Im vorliegenden Beispiel ist vereinfachend angenommen worden, daß die Referenzschwingung sich in Phase mit der Trägerschwingung am Eingang 1 befindet. In der Praxis treten jedoch im Filterkreis 2 und im Begrenzer 3 Phasendrehungen auf. Diese können durch zusätzliche, in Fig. 1 der Übersichtlichkeit halber weggelassene Schaltungselemente kompensiert werden, so daß insgesamt die vom Eingang 1 dem Multiplizierer 5 zugeführte Trägerschwingung mit der vom Begrenzer 3 abgegebenen Referenzschwingung in Phase liegt.

In einem dem Begrenzer 3 nachgeschalteten Phasendreher 4 wird die Referenzschwingung in ihrer Phase um 90° gedreht. In dieser Phasenlage wird die Referenzschwingung dem Multiplizierer 5 zugeführt und in diesem mit der modulierten Trägerschwingung multiplikativ verknüpft. Am Ausgang 7 des Multiplizierers 5 erscheint dann im wesentlichen das Nutzsignal.

Statt der Kompensation der Phasendrehungen im Filterkreis 2 und im Begrenzer 3 können diese - ggf. mit einem darauf abgestimmten Phasendreher - für eine Gesamtphasendrehung von 90° eingerichtet werden. Allerdings erfordert es dann zusätzliche Schaltungselemente, die Trägerschwingung vom Eingang 1 mit der Referenzschwingung in Phase zu legen.

Bei exakter Dimensionierung und exaktem Abgleich des beschriebenen Synchrondemodulators liegt das Maximum der Durchlaßkurve, d.h. das Übertragungsmaximum des Filterkreises 2 exakt bei der Frequenz der Trägerschwingung. Durch Fertigungstoleranzen, Alterungsvorgänge oder auch eine erwünschte Feinverstimmung der Frequenz der Trägerschwingung können jedoch Abweichungen zwischen der Frequenz der Trägerschwingung und dem Maximum der Durchlaßkurve entstehen. Dadurch wird die Trägerschwingung einerseits stärker durch den Filterkreis 2 gedämpft, andererseits fällt das Übertragungsmaximum in den Bereich der Seitenbänder der Trägerschwingung, die dadurch teilweise stärker als die Trägerschwingung übertragen werden, vor allem aber auch mit unterschiedlicher Amplitude. Das Ausgangssignal des Filterkreises 2 weist dann eine zusätzliche Störphasenmodulation auf, die durch den nachfolgenden Begrenzer 3 nicht unterdrückt wird und damit unverändert über den Multiplizierer 5 in das demodulierte Nutzsignal eingestreut wird.

Die genaue Zusammensetzung des Signals am Ausgang 7 des Multiplizierers 5 ist u.a. abhängig vom Phasenwinkel zwischen der Referenzschwingung und der Trägerschwingung. Hat dieser einen Wert von 90°, wie in Fig. 1 dargestellt, entsteht am Ausgang 7 als Mischprodukt u.a. eine Gleichspannung, deren Wert in einem bestimmten Frequenzintervall um die Frequenz der Trägerschwingung herum wenigstens nahezu proportional zu der Abweichung der Frequenz der Trägerschwingung von der Frequenz des Durchlaßmaximums des Filterkreises 2 ist. Diese Gleichspannung wird nun gemäß der Erfindung über eine Leitung 8 dem Filterkreis 2 als Steuerspannung, d.h. als Stellgröße zum Nachsteuern der Frequenz des Durchlaßmaximums, d.h. der Durchlaßfrequenz, zugeleitet. Dadurch wird eine Abweichung dieser Durchlaßfrequenz von der Frequenz der Trägerschwingung wenigstens weitgehend vermieden und eine phasenreine Referenzschwingung gewonnen.

Fig. 2 zeigt eine Abwandlung der Schaltungsanordnung nach Fig. 1, die für die Gewinnung einer Inphasedemodulation der modulierten Trägerschwingung vorgesehen ist, d.h. für den Fall, daß die Trägerschwingung mit einer dazu in Phase liegenden Referenzschwingung demoduliert werden soll, um bestimmte, nur in diesem Fall auftretende Mischprodukte zu erhalten bzw. unerwünschte Mischprodukte zu vermeiden. Die Anordnung nach Fig. 2 umfaßt diejenige nach Fig. 1, wobei einander entsprechende Bauteile wieder mit denselben Bezugszeichen versehen sind. Zusätzlich enthält die Anordnung nach Fig. 2 einen weiteren Multiplizierer 9, dem die Referenzschwingung in Phase mit der modulierten Trägerschwingung zugeführt und mit dieser multiplikativ verknüpft wird. Die Mischprodukte dieser Inphasedemodulation werden am Ausgang 10 des Multiplizierers 9 abgegeben. Selbstverständlich kann parallel dazu auch dem Ausgang 7 ein Nutzsignal entnommen werden.

Fig. 3 zeigt ein etwas detaillierteres Ausführungsbeispiel für den Synchrondemodulator nach Fig. 2, wobei übereinstimmende Schaltungsteile wieder mit identischen Bezugszeichen versehen sind. Entsprechend kann auch die Schaltung nach Fig. 1 ausgestaltet werden. Das Nutzsignal wird hier vom Ausgang 7 über ein aus zwei Längswiderständen 11, 12 und einer Querkapazität 13 gebildetes Tiefpaßfilter dem Filterkreis 2 zugeleitet. Dieser umfaßt einen Sperrkreis aus einer Kapazität 14 und einer Induktivität 15, die zum Abgleich des Filterkreises 2 einstellbar ausgebildet ist. Der Sperrkreis 14, 15 überbrückt einen Arbeitswiderstand 16 - hier einen Kollektorwiderstand - des als Transistor ausgebildeten Vorverstärkers 6. Er ist auf die Frequenz der Trägerschwingung abgestimmt, so daß der Arbeitswiderstand 16 und damit der Vorverstärker 6 nur bzw. im wesentlichen nur bei dieser Frequenz wirksam sind.

Zum Nachsteuern der Durchlaßfrequenz weist der Filterkreis 2 weiterhin zwei in Reihe gegensinnig zueinander angeordnete und parallel zur Kapazität 14 geschaltete Kapazitätsdioden 17, 18 auf, deren Mittelanzapfung 19 die Gleichspannung von der Leitung 8 über das Tiefpaßfilter 11, 12, 13 zugeführt wird. Die Kapazitätswerte der Kapazitätsdioden 17, 18 werden durch die Differenz zwischen der Gleichspannung auf der Leitung 8 und der Versorgungsgleichspannung an dem mit dem Filterkreis 2 verbundenen Gleichspannungsanschluß 20 bestimmt.

In einem anderen, nicht dargestellten Beispiel kann der Filterkreis 2 anstelle der Kapazitätsdioden 17, 18 eine die Durchlaßkurve verändernde Reaktanzschaltung aufweisen, durch die sowohl eine veränderliche Kapazität als auch eine veränderliche Induktivität nachgebildet sein kann. Diese Reaktanzschaltung kann vorzugsweise mit den übrigen Schaltungsteilen auf einem Halbleiterkristall integriert sein. Die erfindungsgemäße Anordnung zum Nachsteuern der Durchlaßfrequenz ist damit kompakt und ohne zusätzliche Beschaltung und zusätzlichen Abgleich aufbaubar. Bei einem solchen Aufbau werden veränderliche Kapazitäten bevorzugt durch Sperrschichtkapazitäten von Transistoren oder dergleichen nachgebildet.

Wahlweise ist es ebenfalls möglich, die Induktivität des Filterkreises 2 als abstimmbare Spule, beispielsweise mit nichtlinearem magnetischem Kern, auszubilden, wobei dann der Induktivitätswert, den diese Spule für eine Kleinsignalaussteuerung aufweist, durch einen Gleichstrom, d.h. durch eine Vormagnetisierung, eingestellt werden kann.

Der Filterkreis 2 in Fig. 3 stellt ein sehr einfaches Beispiel zur Erläuterung der prinzipiellen Wirkungsweise der Schaltungsanordnung dar. Durch entsprechende Modifikation lassen sich auch Filterkreise mit anderen Durchlaßkurven verwenden.

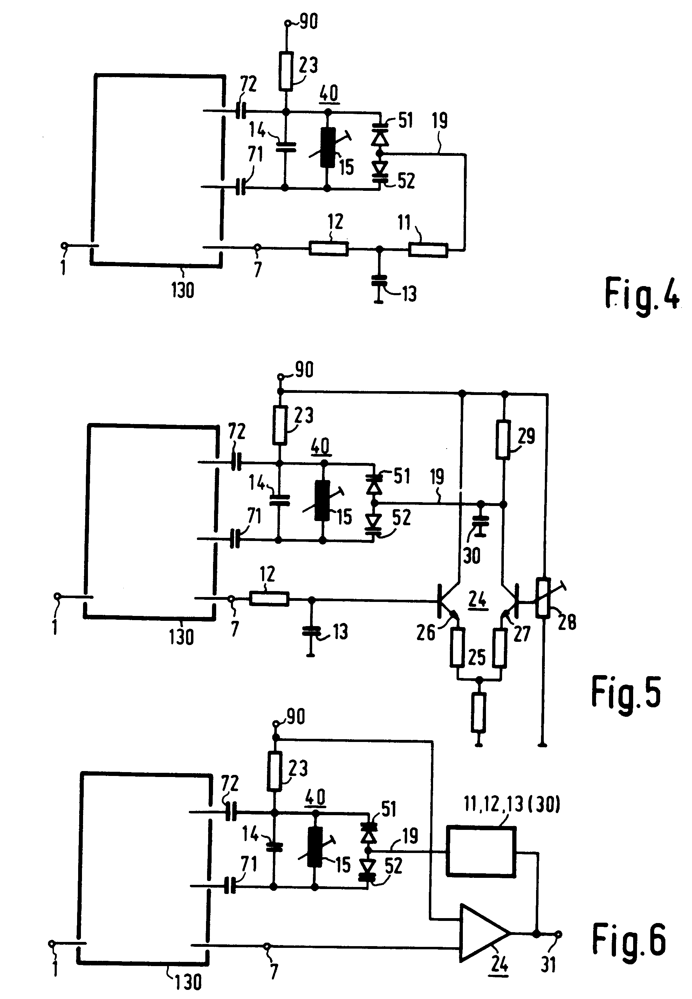

Weitere Beispiele zeigen die Fig. 4 bis 6, in denen im übrigen aus Fig. 3 bekannte Elemente wieder mit identischen Bezugszeichen versehen sind. Insbesondere sind die Schaltungsteile, die in Fig. 3 von der Linie 130 umfaßt sind, für die Anordnungen nach Fig. 4 bis 6 identisch übernommen.

In der Anordnung nach Fig. 4 ist ein abgewandelter Filterkreis 40 eingesetzt, der außer dem beschriebenen Sperrkreis aus der Kapazität 14 und der Induktivität 15 zwei Längskondensatoren 71, 72 umfaßt, die außer dem Übertragungsminimum in der Durchlaßkurve des Filterkreises 40 auch dessen galvanische Abtrennung von der durch die Linie 130 umfaßten Anordnung bewirken. Weiterhin sind zur Kapazität 14 des Sperrkreises zwei gegensinnig in Reihe angeordnete Kapazitätsdioden 51, 52 parallelgeschaltet, die abstimmbare Kapazitäten bilden. An eine Mittelanzapfung 19 zwischen den beiden Kapazitätsdioden 51, 52 wird zum Nachstimmen der Resonanzfrequenz des Filterkreises 40 eine Einstellspannung geführt. Der Filterkreis 40 ist ferner über einen Vorwiderstand 23 an einen Gleichspannungsanschluß 90 gelegt. Zwischen der Mittelanzapfung 19 und dem Gleichspannungsanschluß 90 werden die Kapazitätsdioden 51, 52 gleichmäßig entsprechend der Einstellspannung an der Mittelanzapfung 19 in Sperrichtung vorgespannt und damit ihre Kapazität eingestellt. Die Einstellspannung an der Mittelanzapfung 19 bestimmt damit die Resonanzfrequenz des Sperrkreises 14, 15, 51, 52. Bei einer Verstimmung des Filterkreises 40, d.h. bei einer Abweichung der Resonanzfrequenz des Sperrkreises 14, 15, 51, 52 von der Frequenz des Referenzsignals bzw. der Bildträger-Schwingung, infolge von Alterungsvorgängen, Fertigungstoleranzen oder auch durch erwünschte Feinverstimmung einer vorgeschalteten Empfangsanordnung zur subjektiven Bildverbesserung (sogenanntes "Anspitzen") kann nun durch entsprechende Wahl der Einstellspannung an der Mittelanzapfung 19 die Resonanzfrequenz auf die Frequenz des Referenzsignals abgeglichen werden. Vorteilhaft ist dazu die Einstellspannung ein Maß für die beschriebene Abweichung. Durch die Einstellspannung wird dann die Resonanzfrequenz des Filterkreises 40 der Frequenz des Referenzsignals unmittelbar nachgeführt.

Ein besonders einfaches Beispiel für die Erzeugung der Einstellspannung ist ebenfalls in Fig. 4 dargestellt. Es läßt sich insbesondere dann anwenden, wenn das Referenzsignal gegenüber der Bildträger-Schwingung um im wesentlichen 90° phasenverschoben ist. Die Mischstufe 5 liefert dann an ihren Ausgang 7 neben anderen Signalen ein Gleichspannungs-Mischprodukt, dessen Größe von der Abweichung zwischen der Resonanzfrequenz des Filterkreises 40 und der Frequenz des Referenzsignals direkt abhängt. Die Einstellspannung wird dann bevorzugt als dieses Gleichspannungs-Mischprodukt aus der Mischstufe abgeleitet, und zwar gemäß Fig. 4 wie auch in Fig. 3 über den Tiefpaß aus zwei Längswiderständen 11, 12 und der Querkapazität 13. Der Tiefpaß 11, 12, 13 dient zur Unterdrückung des Einflusses der Tonsignal-Differenzfrequenz-Schwingungen vom Ausgang 7 auf den Filterkreis 40.

Die Anordnung zweier Längskondensatoren 71, 72 beim Filterkreis 40 hat den Vorteil, daß dadurch eine symmetrische Filterkreisanordnung entsteht, wenngleich dafür zwei Kondensatoren (mit doppeltem Kapazitätswert) erforderlich sind.

Die Anordnung des Filterkreises 2 bzw. 40 nach Fig. 3 bzw. 4 stellt nur jeweils eine von mehreren zueinander dualen bzw. äquivalenten Schaltungsvarianten dar, die alle gleichermaßen für die erfindungsgemäße Schaltungsanordnung einsetzbar sind. Diese dualen bzw. äquivalenten Ausführungsformen ergeben sich für den Fachmann nach einfachen netzwerktheoretischen Regeln und sollen daher hier nicht näher erörtert werden.

Fig. 5 zeigt eine Abwandlung der Anordnung nach Fig. 4, in der bereits beschriebene Elemente wieder mit identischen Bezugszeichen versehen sind. In die Anordnung nach Fig. 5 ist gegenüber Fig. 4 ein einen Proportionalregler bildender Verstärker 24 aufgenommen, über den die Einstellspannung vom Ausgang 7 der Mischstufe 5 dem Filterkreis 40 zugeführt wird. Die Einstellspannung wird dazu außerdem über einen durch den Längswiderstand 12 und die Querkapazität 13 gebildeten Tiefpaß geleitet. Der Verstärker 24 besteht aus zwei über ein Emitterwiderstands-Netzwerk 25 aus drei Widerständen emitterseitig gekoppelten Transitoren 26, 27, von denen dem einen Transistor 26 an seinem Basisanschluß die Einstellspannung und dem anderen Transistor 27 an seinem Basisanschluß eine über einen Widerstandsspannungsteiler 28 vom Gleichspannungsanschluß 90 abgeleitete Gleichvorspannung zugeführt wird. Die Kollektoranschlüsse der Transistoren 26, 27 sind einerseits unmittelbar und andererseits über einen Kollektorwiderstand 29 ebenfalls mit dem Gleichspannungsanschluß 90 verbunden. Vom Verbindungspunkt des Kollektorwiderstands 29 mit dem Kollektoranschluß des Transistors 27 wird die verstärkte Einstellspannung der Mittelanzapfung 19 zugeführt. Ein Siebkondensator 30 dient zum Kurzschließen restlicher Wechselspannungsanteile in der Einstellspannung an der Mittelanzapfung 19.

Die Proportionalregelung bei den im vorstehenden beschriebenen Anordnungen stellt sicher, daß die Einstellspannung beim Ausregeln der Abweichung der Resonanzfrequenz von der Frequenz des Referenzsignals ein Maß für die Frequenzabweichung ist und somit einen einfachen Abgleich in der Fertigung ermöglicht sowie einfach aufgebaut ist. Es zeigt sich, daß diese einfache, direkte Regelung auch bei einem verbleibenden Regelfehler hinreichend genau arbeitet. Soll statt dessen eine genauere Regelung zur Ausschaltung des Regelfehlers angewandt werden, beispielsweise eine Integralregelung, ist eine aufwendigere Erzeugung der Einstellspannung nötig.

Fig. 6 zeigt eine Abwandlung der Anordnung nach Fig. 5, bei der der Verstärker 24 dem Tiefpaß 11, 12, 13 und ggf. 30 vorgeschaltet ist und dadurch zusätzlich einen Ausgangsverstärker für die Tonsignal-Differenzfrequenz-Schwingung bildet. Die Elemente entsprechen im übrigen denen der Fig. 5 und sind daher größtenteils nur blockschematisch wiedergegeben. Der Verstärker 24 weist hierbei einen Ausgang 31 auf, an dem die verstärkte Tonsignal-Differenzfrequenz-Schwingung und das verstärkte Gleichspannungs-Mischprodukt abgegriffen werden können. Letzteres wird über den Tiefpaß 11, 12, 13 und ggf. 30 der Mittelanzapfung 19 zugeleitet.

In einer - nicht dargestellten - Abwandlung der Anordnungen nach den Fig. 5 bzw. 6 wird dem Verstärker 24 eine temperaturkompensierte Gleichvorspannung derart zugeleitet, daß die Einstellspannung an der Mittelanzapfung 19 temperaturunabhängig ist. Dadurch werden Einflüsse von Erwärmungseffekten auf die Übertragungseigenschaften der Demodulationsanordnung vermieden. Insbesondere wird dafür der Widerstands-Spannungsteiler 28 durch einen mit einer Temperaturkompensation versehenen Spannungsteiler ersetzt. Dieser enthält vorzugsweise eine oder mehrere Dioden oder als Dioden geschaltete Transistoren.

Weiterhin können in den Anordnungen nach den Fig. 4, 5 oder 6 Mittelanzapfung 19 und Gleichspannungsanschluß 90 derart vertauscht werden, daß die Gleichspannung vom Gleichspannungsanschluß 90 über den Vorwiderstand 23 der Mittelanzapfung 19 und die Einstellspannung statt dessen über den Punkt des Filterkreises 40 zugeführt wird, an dem in den dargestellten Anordnungen die Gleichspannung über den Vorwiderstand 23 zugeführt wird.

In einer weiteren Abwandlung der Fig. 4, 5 oder 6 können der Gleichspannungsanschluß 90, der zugehörige Vorwiderstand 23 und der Längskondensator 72 entfallen, wenn die Gleichspannungsversorgung statt dessen aus den von der Linie 130 umfaßten Schaltungsteilen erfolgt, insbesondere über den Kollektorwiderstand 16 gemäß Fig. 3.

In einem weiteren, vorteilhaften Ausführungsbeispiel können zusätzlich zu den durch die Linie 130 umfaßten Schaltungsteilen auch die Längskondensatoren 71, 72, die Kapazitätsdioden 51, 52, der Verstärker 24 mit zugehöriger Beschaltung sowie gegebenenfalls der Tiefpaß 11, 12, 13 (gegebenenfalls 30) auf demselben Halbleiterkristall integriert sein.

## Patentansprüche

1. Synchrondemodulator zum Demodulieren einer mit einem Nutzsignal modulierten Trägerschwingung (1), mit einem Filterkreis (2), der die Trägerschwingung aus der mit dem Nutzsignal modulierten Trägerschwingung abtrennt, einem Begrenzer (3), der eine amplitudenbegrenzte Referenzschwingung aus der Trägerschwingung erzeugt, einem Phasendreher (4), der die Phase der Referenzschwingung auf einen Phasenwinkel von im wesentlichen 90° gegenüber der Trägerschwingung verschiebt, und einem Multiplizierer (5), der die modulierte Trägerschwingung mit der in der Phase auf im wesentlichen um 90° gegenüber der Trägerschwingung verschobenen Referenzschwingung multiplikativ verknüpft, dadurch gekennzeichnet, daß eine vom Multiplizierer (5) als Verknüpfungsprodukt gelieferte Gleichspannung als Maß für die Frequenzabweichung der Trägerschwingung von der Durchlaßfrequenz des Filterkreises (2) diesem als Stellgröße zum Nachsteuern der Durchlaßfrequenz (8) zugeführt wird.

2. Synchrondemodulator nach Anspruch 1,
gekennzeichnet durch einen weiteren Multiplizierer (9), dem die Referenzschwingung in Phase mit der modulierten Trägerschwingung zuführbar ist zum Gewinnen eines (demodulierten) Inphase-Nutzsignals (an 10).

3. Synchrondemodulator nach Anspruch 1 oder 2,
dadurch gekennzeichnet, daß der Filterkreis (2) ein abstimmbares Element enthält, dem die Gleichspannung als Einstellspannung zum Nachsteuern der Durchlaßfrequenz zuführbar ist (über 8).

4. Synchrondemodulator nach Anspruch 3,
dadurch gekennzeichnet, daß das abstimmbare Element wenigstens eine abstimmbare Kapazität (17, 18) umfaßt.

5. Synchrondemodulator nach Anspruch 3,
dadurch gekennzeichnet, daß die Einstellspannung (an 19) vom Ausgang (7) der Mischstufe (5) über einen Tiefpaß (12, 13, 30) und einen einen Proportionalregler bildenden Verstärker (24) dem Filterkreis (2) zugeführt wird.

6. Synchrondemodulator nach Anspruch 5,
dadurch gekennzeichnet, daß der Verstärker (24) dem Tiefpaß (11, 12, 13, eventuell 30) vorgeschaltet ist und zusätzlich einen Ausgangsverstärker für das Nutzsignal bildet.

7. Synchrondemodulator nach Anspruch 5 oder 6,
dadurch gekennzeichnet, daß dem Verstärker (24) eine temperaturkompensierte Gleichspannung zugeleitet wird derart, daß die Einstellspannung (an 19) temperaturunabhängig ist.

8. Synchrondemodulator nach einem der vorhergehenden Ansprüche zum Gewinnen wenigstens einer Tonsignal-Differenzfrequenz-Schwingung aus einem Fernsehsignal, das eine amplitudenmodulierte Bildträger-Schwingung und wenigstens eine modulierte Tonträger-Schwingung enthält,
dadurch gekennzeichnet, daß der Filterkreis (2) ein Übertragungsminimum (Nullstelle) bei der Frequenz der amplitudenstärksten Tonträger-Schwingung aufweist.

9. Synchrondemodulator nach Anspruch 8, bei dem der Filterkreis (2) einen Sperrkreis (14, 15) enthält, der eine Arbeitsimpedanz (16) eines Vorverstärkers (6) überbrückt,
dadurch gekennzeichnet, daß das Übertragungsminimum durch wenigstens einen in Reihe zum Sperrkreis (14, 15) angeordneten Längskondensator (71, 72) gebildet ist.

10. Synchrondemodulator nach Anspruch 5, 6 oder 7,
dadurch gekennzeichnet, daß er mit dem Verstärker (24), den Längskondensatoren (71, 72) und den abstimmbaren Kapazitäten (17, 18) sowie gegebenenfalls dem Tiefpaß (11, 12, 13, evtl. 30) zusammen auf einem Halbleiterkristall integriert ist.

## Claims

1. A synchronous demodulator for demodulating a carrier wave (1) modulated with a useful signal, which demodulator comprises a filter circuit (2) for extracting the carrier wave from the carrier wave (1) modulated with the useful signal, a limiter (3) for generating an amplitude-limited reference wave from the carrier wave, a phase shifter (4) which shifts the phase of the reference wave through a phase angle of substantially 90° relative to the carrier wave, and a multiplier (5) which multiplies the modulated carrier wave by the reference wave which has been phase-shifted through substantially 90° relative to the carrier wave,
characterised in that as a measure of the frequency deviation of the carrier wave from the pass frequency of the filter circuit (2) a direct voltage supplied as a mixing product by the multiplier (5) is applied to this filter circuit as a control parameter for controlling the pass frequency (8).

2. A synchronous demodulator as claimed in Claim 1,
characterised by a further multiplier (9) to which the reference wave can be applied in phase with the modulated carrier wave in order to obtain a (demodulated) in-phase useful signal (at 10).

3. A synchronous demodulator as claimed in Claim 1 or 2,
characterised in that the filter circuit (2) includes a tunable element to which the direct voltage can be applied (*via* 8) as a control voltage for controlling the pass frequency.

4. A synchronous demodulator as claimed in Claim 3,
characterised in that the tunable element comprises at least one tunable capacitance (17, 18).

5. A synchronous demodulator as claimed in Claim 3,
characterised in that the control voltage (at 19) is applied to the filter circuit (2) from the output (7) of the mixer stage (5) *via* a low-pass filter (12, 13, 30) and an amplifier (24) constituting a proportional controller.

6. A synchronous demodulator as claimed in Claim 5,
characterised in that the amplifier (24) precedes the low-pass filter (11, 12, 13, and optionally 30) and in addition constitutes an output amplifier for the useful signal.

7. A synchronous demodulator as claimed in Claim 5 or 6,
characterised in that a temperature-compensated direct voltage is applied to the amplifier (24) in such a way that the control voltage (at 19) is temperature-independent.

8. A synchronous demodulator as claimed in any one of the preceding Claims, for deriving at least one sound-signal difference frequency from a television signal comprising an amplitude-modulated picture carrier wave and at least one modulated sound carrier wave,
characterised in that the filter circuit (2) has a transmission minimum (zero) at the frequency of the highest-amplitude sound carrier wave

9. A synchronous demodulator as claimed in Claim 8, in which the filter circuit (2) comprises a wave trap (14, 15) which shunts a load impedance (16) of a preamplifier (6),
characterised in that the transmission minimum is formed by at least one series capacitor (71, 72) arranged in series with the wave trap (14, 15).

10. A synchronous demodulator as claimed in Claim 5, 6 or 7,
characterised in that it is integrated on a semiconductor crystal together with the amplifier (24), the series capacitors (71, 72) and the tunable capacitances (17, 18) and possibly the low-pass filter ( 11, 12, 13, possibly 30).

## Revendications

1. Démodulateur synchrone pour démoduler une oscillation porteuse (1) modulée par un signal utile, comportant un circuit de filtrage (2), qui sépare l'oscillation porteuse de l'oscillation porteuse modulée par le signal utile, un limiteur (3), qui produit une oscillation de référence limitée en amplitude à partir de l'oscillation porteuse, un rotateur de phase (4), qui fait tourner la phase de l'oscillation de référence d'un angle de phase en substance de 90° vis-à-vis de l'oscillation porteuse, et un multiplicateur (5), qui combine par multiplication l'oscillation porteuse modulée avec l'oscillation de référence décalée en phase en substance de 90° vis-à-vis de l'oscillation porteuse, caractérisé en ce qu'une tension continue délivrée par le multiplicateur (5) en tant que produit de combinaison pour la mesure de l'écart de fréquence de l'oscillation porteuse vis-à-vis de la fréquence de passage du circuit de filtrage (2), est acheminée à ce dernier comme grandeur de réglage pour asservir la fréquence de passage (via 8).

2. Démodulateur synchrone selon la revendication 1, caractérisé par un autre multiplicateur (9) auquel l'oscillation de référence en phase, avec l'oscillation porteuse modulée, peut être acheminée pour obtenir un signal utile en phase (démodulé) (en 10).

3. Démodulateur synchrone selon la revendication 1 ou 2, caractérisé en ce que le circuit de filtrage (2) contient un élément accordable auquel la tension continue peut être acheminée comme tension de réglage pour asservir la fréquence de passage (via 8).

4. Démodulateur synchrone selon la revendication 3, caractérisé en ce que l'élément accordable contient au moins une capacité accordable (17, 18).

5. Démodulateur synchrone selon la revendication 3, caractérisé en ce que la tension de réglage (en 19) est acheminée de la sortie (7) de l'étage de mélange (5) au circuit de filtrage (2) via un filtre passe-bas (12, 13, 30) et un amplificateur (24) formant un régulateur proportionnel.

6. Démodulateur synchrone selon la revendication 5, caractérisé en ce que l'amplificateur (24) est monté en amont du filtre passe-bas (11, 12, 13, éventuellement 30) et forme, en outre, un amplificateur de sortie pour le signal utile.

7. Démodulateur synchrone selon la revendication 5 ou 6, caractérisé en ce qu'une tension continue compensée en température est acheminée à l'amplificateur (24), de telle sorte que la tension de réglage (en 19) soit indépendante de la température.

8. Démodulateur synchrone selon l'une quelconque des revendications précédentes, pour obtenir au moins une oscillation de fréquence différentielle du signal audio à partir d'un signal de télévision, qui contient une oscillation de porteuse image modulée en amplitude et au moins une oscillation de porteuse audio modulée, caractérisé en ce que le circuit de filtrage (2) présente un minimum de transmission (point zéro) à la fréquence de l'oscillation de la porteuse audio de la plus forte amplitude.

9. Démodulateur synchrone selon la revendication 8, dans laquelle le circuit de filtrage (2) contient un circuit bouchon (14, 15), qui ponte une impédance de travail (16) d'un préamplificateur (6), caractérisé en ce que le minimum de transmission est formé par au moins un condensateur longitudinal (71, 72) agencé en série avec le circuit bouchon (14, 15).

10. Démodulateur synchrone selon la revendication 5, 6 ou 7, caractérisé en ce qu'il est intégré conjointement avec l'amplificateur (24), les condensateurs longitudinaux (71, 72) et les capacités accordables (17, 18) ainsi qu'éventuellement avec le filtre passe-bas (11, 12, 13, éventuellement 30) sur un cristal semi-conducteur.
